Europäisches Patentamt

European Patent Office

Office européen des brevets

(19)

(11) Veröffentlichungsnummer: **0 342 329 B1**

(12) **EUROPÄISCHE PATENTSCHRIFT**

(45) Veröffentlichungstag der Patentschrift: **04.08.93**

(51) Int. Cl.⁵: **H03H 11/24**

(21) Anmeldenummer: **89104365.5**

(22) Anmeldetag: **11.03.89**

(54) **Regelbarer Dämpfungsvierpol mit konstantem Eingangs- und Ausgangswiderstand.**

(30) Priorität: **19.05.88 CH 1906/88**

(43) Veröffentlichungstag der Anmeldung:
**23.11.89 Patentblatt 89/47**

(45) Bekanntmachung des Hinweises auf die
Patenterteilung:
**04.08.93 Patentblatt 93/31**

(84) Benannte Vertragsstaaten:
**CH DE FR GB IT LI NL SE**

(56) Entgegenhaltungen:
**DE-A- 2 546 405**

**IEEE 1986 MICROWAVE AND MILLIMETER-WAVE MONOLITHIC CIRCUITS SYMPOSIUM, 1982, Seiten 75-79; G.S. BARTA et al.: "A 2 to 8 GHz leveling loop using a GaAs MMIC active splitter and attenuator"**

**PATENT ABSTRACTS OF JAPAN, Band 3, Nr. 113 (E-139), 19, September 1979, Seite 71 E 139; & JP-A-54 91 034 (NIPPON DENKI K.K.) 19-07-1979**

**1982 IEEE MTT-S INTERNATIONAL MICROWA-VE SYMPOSIUM DIGEST, 15.-17. Juni 1982, Dallas, Seiten 479-481, IEEE, New York, US; Y.**

**TAJIMA et al.: "GaAs monolithic wideband (2-18 GHz) variable attenuators"**

(73) Patentinhaber: **SIEMENS-ALBIS AKTIENGE-SELLSCHAFT PV/Patente und Verträge Postfach CH-8047 Zürich(CH)**

(72) Erfinder: **Lauper, Alfred Wydäckerring 69 CH-8047 Zürich(CH)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft Dämpfungsvierpole nach den Oberbegriffen der Ansprüche 1, 2 oder 3 sowie eine Verwendung dieser Dämpfungsvierpole.

Als Dämpfungsvierpole mit konstantem Eingangs- und Ausgangswiderstand werden in der Elektrotechnik vielfach sogenannte längssymmetrische, überbrückte T-Glieder eingesetzt, die aus einem überbrückenden Längswiderstand $R_A = R \times q$, zwei identischen Zweigwiderständen $R_C$ und $R_D$ und einem Querwiderstand $R_B = R \div q$ bestehen, worin q ein Parameter ist, der so gewählt ist, dass die Beziehung $(R \times q)(R \div q) = R^2$, also Dualität gilt. Falls z.B. $R_A$ variiert wird um die Dämpfung des T- Gliedes zu verändern, muss $R_B$ derart nachgeregelt werden, dass die Dualität zwischen $R_A$ und $R_B$ erhalten bleibt. Längssymmetrische T- oder $\Pi$ Glieder haben dabei den Vorteil, dass deren Eingangs- und Ausgangswiderstand gleich sind. Da Gleich- und Wechselstromwiderstand eines Feldeffekttransistors nahezu identisch sind, können die Widerstände $R_A$ und $R_B$ durch Feldeffekttransistoren, die als spannungsgesteuerte Widerstände dienen, ersetzt werden.

Die Regelung des Querwiderstandes erfolgt dabei oft parallel zur Regelung des Querwiderstandes eines identischen zweiten T-Gliedes, nachdem dessen überbrückender Längswiderstand um dasselbe Mass variiert wurde wie der Längswiderstand des ersten T-Gliedes und dessen Ausgangswiderstand innerhalb einer Brückenschaltung mit einem Referenzwiderstand verglichen und durch Regelung des Querwiderstandes des zweiten T-Gliedes konstant gehalten wird. Eine solche Lösung ist aus IEEE Transactions on Microwave Theorie and Techniques, Vol. MTT-34, No. 12, December 1986, Seite 1570 bzw. aus IEEE 1986, Microwave and Millimeter-Wave Monolythics Symposium, 1982, Seiten 75-79; G.S. Barta et al. :"A 2 to 8 GHz leveling loop using a GaAs MMIC active splitter and attenuator" bekannt. Unvorteilhaft bei dieser Lösung ist, dass der Einsatz eines zweiten, nur mit grossem Aufwand herstellbaren, identischen T- bzw. $\Pi$-Gliedes notwendig ist. Dabei ist die Dämpfung des Dämpfungsvierpols von der Temperaturstabilität der für das erste T- Glied verwendeten Bauteile abhängig. Zudem ist dessen Steuerkennlinie nicht linear.

Der vorliegenden Erfindung liegt daher die Aufgabe zugrunde, einen regelbaren Dämpfungsvierpol mit einem T- oder $\Pi$-Glied der eingangs erwähnten Art zu schaffen, der ein einziges T- bzw. ein einziges $\Pi$-Glied enthält. Die Lösung dieser Aufgabe gelingt erfindungsgemäss mit einer Schaltung, wie sie im Kennzeichen der Ansprüche 1, 2 oder 3 umschrieben ist. Vorteilhafte Ausgestaltungen der Erfindung sind in weiteren Ansprüchen angegeben.

Ein Vorteil des vorgeschlagenen Dämpfungsvierpols ist, dass zur Einstellung der Dämpfung und zur Konstanthaltung der Eingangs- und Ausgangsimpedanz zwei Regelkreise auf nur ein T- oder $\Pi$-Glied einwirken. Probleme der Anpassung des verwendeten T- oder $\Pi$-Gliedes auf ein zweites T- oder $\Pi$- Glied entfallen demnach. Die verbesserte Temperaturstabilität des Dämpfungsvierpols ist nur noch von passiven Bauteilen abhängig. Dabei erfolgt die Dämpfung linear zur eingestellten Steuer- bzw. Sollspannung $V_S$.

Anhand einer Zeichnung werden mehrere Ausführungsbeispiele nachfolgend näher erläutert. Dabei zeigt:

Fig. 1     den erfindungsgemässen Dämpfungsvierpol mit einem überbrückten T-Glied

Fig. 2     den erfindungsgemässen Dämpfungsvierpol mit einem nicht überbrückten T-Glied

Fig. 3     den erfindungsgemässen Dämpfungsvierpol mit einem $\Pi$-Glied.

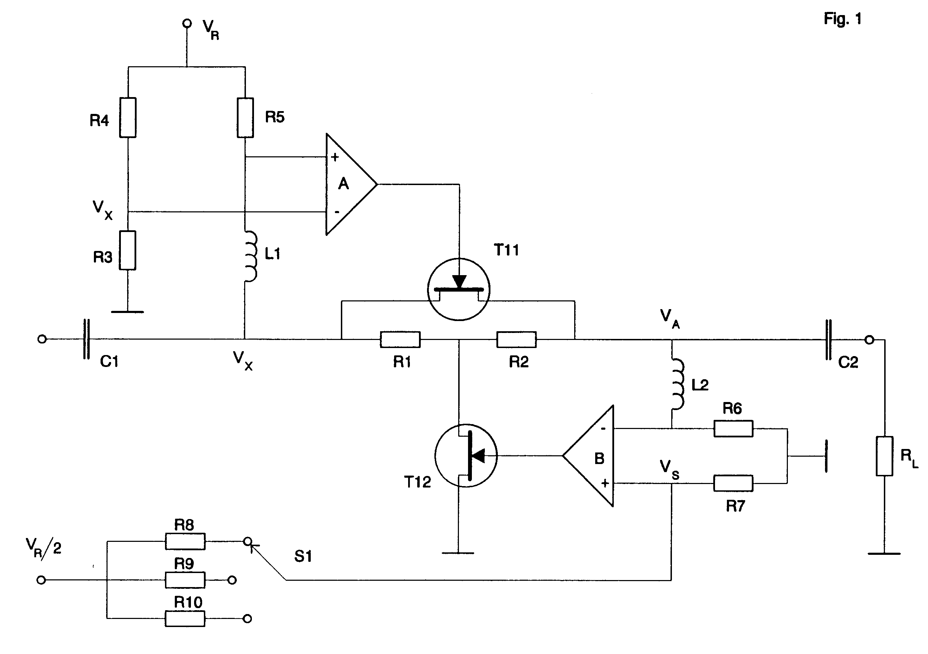

Fig. 1 zeigt ein überbrücktes T-Glied mit einem den überbrückenden Längswiderstand bildenden Feldeffekttransistor T11 und den Längswiderständen R1 und R2 und einem den Querwiderstand bildenden Feldeffekttransistor T12. Das T-Glied ist in eine erste Brückenschaltung mit den Widerständen R3, R4 und R5 integriert, wobei der Eingangswiderstand $R_{ein}$ des T-Gliedes den vierten Widerstand der Brückenschaltung bildet. Ferner ist das T-Glied in eine zweite Brückenschaltung integriert, indem der Spannungsabfall über dem T-Glied mit dem Spannungsabfall über dem Widerstand R8 bzw. R9 oder R10 durch einen Operationsverstärker B verglichen wird. Die erste Brückenschaltung liegt an einem Speisepotential $V_R$. Die am Potential $1/2\ V_R$ liegenden Widerstände R8, R9 und R10 sind wahlweise über einen Schalter S1 an die zweite Brückenschaltung anschaltbar, wodurch eine gewünschte Dämpfung eingestellt werden kann. Im Abgleichzweig der ersten Brückenschaltung ist ein Operationsverstärker A eingefügt, dessen Ausgang mit der Steuerelektrode (Gate) des Transistors T11 verbunden ist. Ebenso ist im Abgleichzweig der zweiten Brückenschaltung der Operationsverstärker B eingefügt, dessen Ausgang mit dem Gate des Transistors T12 verbunden ist. Die Widerstände wurden einfachheitshalber wie folgt gewählt: R1, R2, R3, R4, R5, R7, R8 und $R_L = R_W$, R9 $= 3R_W$ und R10 $= 7R_W$. Der Widerstand R6 muss dabei dem Lastwiderstand $R_L$ des Dämpfungsvierpols entsprechen, der gleich dem Wert des Wellenwiderstandes $R_W$ gewählt wurde. Andere Widerstandskombinationen sind denkbar, so z.B. für andere Dämpfungswerte. Die Spulen L1 und L2 dienen zur wechselspannungsmässigen Trennung des T-Gliedes von der restlichen Schaltung. Die Kondensatoren C1 und C2 trennen das T-Glied gleichspannungsmässig vom Eingang bzw. Ausgang des Dämpfungsvierpols.

Die Funktionsweise der Schaltung ist folgende: In der ersten Brückenschaltung wird der Eingangswiderstand $R_{ein}$ des T-Gliedes mit dem Widerstand R3 durch den Operationsverstärker A verglichen, welcher den Transistor T11 derart steuert, dass die Bedingung $R_{ein}$ = R3 eingehalten wird. Nachdem die Brücke abgeglichen ist, liegt an beiden Eingängen des Operationsverstärkers A dieselbe Spannung $V_X$ = $(V_R \times R3) \div (R3 + R4)$. Die Spannung $V_X$, welche im vorliegenden Fall (R3 = R4) gleich dem halben Speisepotential $V_R$ ist ($V_X$ = 1/2 $V_R$), ist zugleich die Eingangsgleichspannung für das T-Glied. Die Ausgangsgleichspannung $V_A$ des T-Gliedes wird nun mit der über den Schalter S1 entsprechend der gewünschten Dampfung vorgewählten Sollspannung $V_S$ durch den Operationsverstärker B verglichen, der den Transistor T12 so steuert, dass die Ausgangsgleichspannung $V_A$ den Wert der Sollspannung $V_S$ annimmt und somit die gewünschte Dämpfung eintritt.

Durch Teilung der Gleichspannung $V_X$ durch das T-Glied und den Widerstand R6 ergibt sich die Ausgangsgleichspannung $V_A$ des T-Gliedes, welche dem invertierenden Eingang des Operationsverstärkers B zugeführt wird. Die Spule L2 und der Kondensator C2 sind so dimensioniert, dass für Gleichspannungen der Widerstand R6 als Lastwiderstand dient (Spule L2 leitet, Kondensator C2 sperrt), und dass für Wechselspannungen im Arbeitsbereich des Dämpfungsvierpols der Widerstand $R_L$ als Lastwiderstand dient (Spule L2 sperrt, Kondensator C2 leitet). Damit die Dämpfung des T-Gliedes für Gleich- und Wechselspannungen gleich ist, müssen die Widerstände R6 und $R_L$ den gleichen Widerstandswert aufweisen. Normalerweise sind beide gleich dem Wellenwiderstand $R_W$. Nachdem die Eingangsgleichspannung $V_X$ des T-Gliedes bekannt ist, kann der Wert der Ausgangsgleichspannung $V_A$ für eine gewünschte Dämpfung $L_u$ durch die Formel $L_u$ = 20 log $(V_A / V_X)$ berechnet werden. Der Wert der berechneten Ausgangsgleichspannung $V_A$ wird durch Teilung der Spannung $V_R/2$ durch die Widerstände R7 und R8 bzw. R9 oder R10 eingestellt und über den Schalter S1 dem nicht-invertierenden Eingang des Operationsverstärkers B als Sollspannung zugeführt. Der Operationsverstärker B steuert nun den Transistor T12 derart, dass die Ausgangsgleichspannung des T-Gliedes den Wert der Sollspannung annimmt und damit die gewünschte Dämpfung eintritt. Die Werte für die Widerstände R8, R9 und R10 lassen sich auch wie folgt berechnen :

Durch Substitution der Variablen $V_A$ und $V_X$ in der Formel $L_u$ = 20 log $(V_A / V_X)$ mit $V_A$ = (0,5 VR × R7) : (R7 + R8/9/10) und $V_X$ = (VR × R3) : (R3 + R4) und durch Einsetzen von $R_W$ anstelle von R3, R4 und R7 ergibt sich folgende Formel, welche zur Berechnung der Widerstände R8, R9 und R10 für gewünschte Dämpfungswerte dient :

$$ Lu = 20 \log \frac{1}{1 + \dfrac{R8/9/10}{RW}} $$

Die Zuschaltung des Widerstandes R8 = $R_W$ führt dabei zu einer Dämpfung von 6dB, die Zuschaltung des Widerstandes R9 = $3R_W$ ergibt eine Dämpfung von 12dB und die Zuschaltung von Widerstand R10 = $7R_W$ ergibt eine Dämpfung von 18dB. Der Eingangs- bzw. der Ausgangswiderstand des Dämpfungsvierpols werden dabei wiederum durch den Operationsverstärker A, der den Eingangswiderstand $R_{ein}$ des T-Gliedes mit dem Widerstand R3 vergleicht und der den Feldeffekttransistor T11 entsprechend steuert, konstantgehalten.

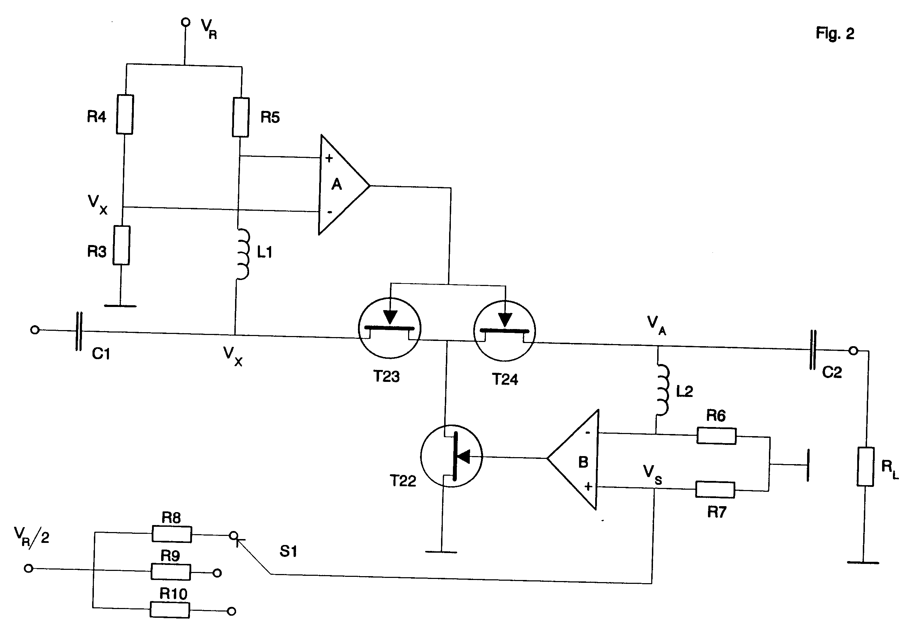

Fig. 2 zeigt eine weitere Ausführungsform der Erfindung. Das überbrückte T-Glied gemäss Fig. 1 wird darin durch ein in dieser Schaltung bezüglich Vierpolparameter äquivalentes nicht überbrücktes T-Glied, bestehend aus zwei regelbaren Längswiderständen (Feldeffekttransistoren T23 und T24) und einem regelbaren Querwiderstand (Feldeffekttransistor T22), ersetzt. Die Steuerelektroden der zwei Feldeffekttransistoren T23 und T24 sind dabei mit dem Ausgang des Operationsverstärkers A verbunden; die Steuerelektrode des Feldeffekttransistors T22 ist mit dem Ausgang des Operationsverstärkers B verbunden.

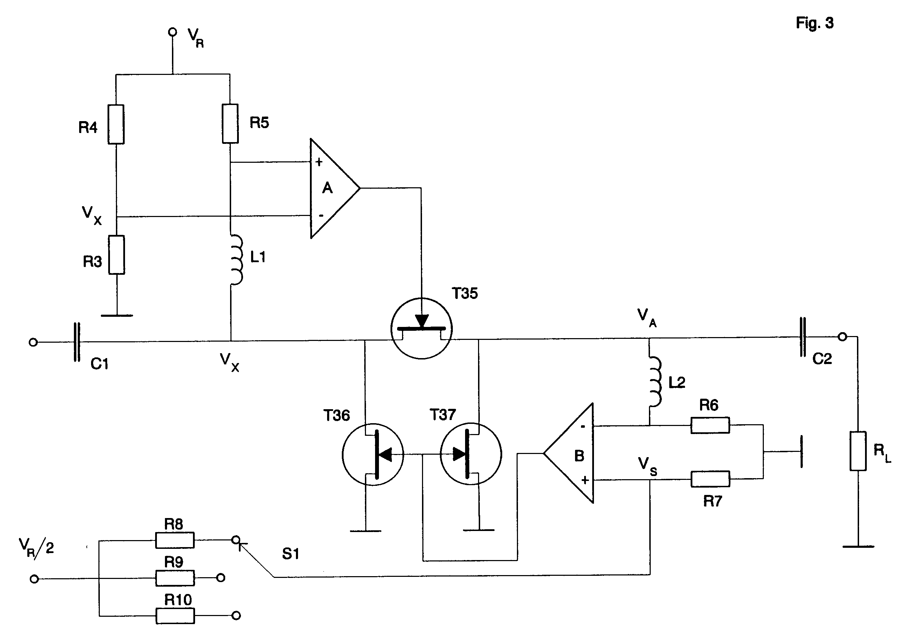

Fig. 3 zeigt eine dritte Ausführungsform der Erfindung. Das überbrückte T-Glied gemäss Fig. 1 wird hier durch ein in dieser Schaltung bezüglich Vierpolparameter äquivalentes Π-Glied, bestehend aus einem regelbaren Längswiderstand (Feldeffekttransistor T35) und zwei regelbaren Querwiderständen (Feldeffekttransistoren T36 und T37), ersetzt. Die Steuerelektrode des Feldeffekttransistors T35 ist dabei mit dem Ausgang des Operationsverstärkers A verbunden. Die Steuerelektroden der Feldeffekttransistoren T36 und T37 sind dabei mit dem Ausgang des Operationsverstärkers B verbunden. Die Funktionsweise der Schaltungen gemäss Fig. 2 und Fig. 3 ist identisch mit derjenigen von Fig. 1.

Für gleiche Dämpfung und gleichen Eingangs- und Ausgangswiderstand nehmen die Vierpolparameter für das überbrückte T-Glied, das reine T-Glied und das Π-Glied durch Steuerung der relevanten Feldeffekttransistoren den gleichen Wert an.

Zum Erzielen von höheren Dämpfungswerten können zwei (oder mehrere) identische T-oder Π-Glieder seriell zusammengeschaltet werden. Die Steuerung der weiteren regelbaren Widerstände erfolgt dabei parallel zu den entsprechenden regelbaren Widerständen des ersten T- bzw. Π-Gliedes.

**Patentansprüche**

1. Regelbarer Dämpfungsvierpol mit konstantem Eingangs- und Ausgangswiderstand, bestehend aus einem längssymmetrischen, überbrückten T- Glied mit einem regelbaren überbrückenden Längswiderstand (T11) und einem regelbaren Querwiderstand (T12), **dadurch gekennzeichnet,** dass der überbrückende Längswiderstand (T11) von einem ersten Operationsverstärker (A), der den Eingangswiderstand des T-Gliedes mit den restlichen drei Widerständen (R3, R4, R5) einer ersten Brückenschaltung vergleicht, so geregelt wird, dass der Eingangswiderstand des T-Gliedes konstant bleibt, und dass der regelbare Querwiderstand (T12) von einem zweiten Operationsverstärker (B), der den Gleichspannungsanteil der Ausgangsspannung des T-Gliedes in einer zweiten Brückenschaltung mit einer entsprechend einer gewünschten Dämpfung vorgewählten Sollspannung vergleicht, so geregelt wird, dass dieser Gleichspannungsanteil den Wert der Sollspannung annimmt und der Dämpfungsvierpol dadurch die gewünschte Dämpfung erhält.

2. Regelbarer Dämpfungsvierpol mit konstantem Eingangs- und Ausgangswiderstand, bestehend aus einem längssymmetrischen T-Glied mit zwei regelbaren Längswiderständen (T23 und T24) und einem regelbaren Querwiderstand (T22), **dadurch gekennzeichnet,** dass die regelbaren Längswiderstände (T23 und T24) von einem ersten Operationsverstärker (A), der den Eingangswiderstand des T-Gliedes mit den restlichen drei Widerständen (R3, R4, R5) einer ersten Brückenschaltung vergleicht, so geregelt wird, dass der Eingangswiderstand des T-Gliedes konstant bleibt, und dass der regelbare Querwiderstand (T22) von einem zweiten Operationsverstärker (B), der den Gleichspannungsanteil der Ausgangsspannung des T-Gliedes in einer zweiten Brückenschaltung mit einer entsprechend einer gewünschten Dämpfung vorgewählten Sollspannung vergleicht, so geregelt wird, dass dieser Gleichspannungsanteil den Wert der Sollspannung annimmt und der Dämpfungsvierpol dadurch die gewünschte Dämpfung erhält.

3. Regelbarer Dämpfungsvierpol mit konstantem Eingangs- und Ausgangswiderstand, bestehend aus einem längssymmetrischen Π-Glied mit einem regelbaren Längswiderstand (T35) und zwei regelbaren Querwiderständen (T36 und T37), **dadurch gekennzeichnet,** dass der regelbare Längswiderstand (T35) von einem ersten Operationsverstärker (A), der den Eingangswiderstand des Π-Gliedes mit den restlichen drei Widerständen (R3, R4, R5) einer ersten Brückenschaltung vergleicht, so geregelt wird, dass der Eingangswiderstand des Π-Gliedes konstant bleibt, und dass die regelbaren Querwiderstände (T36 und T37) von einem zweiten Operationsverstärker (B), der den Gleichspannungsanteil der Ausgangsspannung des Π-Gliedes in einer zweiten Brückenschaltung mit einer entsprechend einer gewünschten Dämpfung vorgewählten Sollspannung vergleicht, so geregelt wird, dass dieser Gleichspannungsanteil den Wert der Sollspannung annimmt und der Dämpfungsvierpol dadurch die gewünschte Dämpfung erhält.

4. Regelbarer Dämpfungsvierpol mit einem ersten Dämpfungsvierpol, dessen Eingangswiderstand und Dämpfungsfaktor geregelt werden, nach einem der vorhergehenden Ansprüche, **dadurch gekennzeichnet,** dass die Ausgänge der Operationsverstärker (A, B) mit den Eingängen der entsprechenden Längs- bzw. Querwiderstände mindestens eines zweiten Dämpfungsvierpoles verbunden sind.

5. Regelbarer Dämpfungsvierpol nach Anspruch 4, **dadurch gekennzeichnet,** dass der zweite bzw. die weiteren Vierpole ein zumindest annähernd identisches Steuerungs- bzw. Regelungsverhalten aufweisen.

6. Regelbarer Dämpfungsvierpol nach Anspruch 4 oder 5, **dadurch gekennzeichnet,** dass dem ersten und/oder den weiteren Dämpfungsvierpolen ein Hochfrequenzsignal zuführbar ist.

7. Regelbarer Dämpfungsvierpol nach Anspruch 1, 2 oder 3, **dadurch gekennzeichnet,** dass die entsprechenden Eingänge der Operationsverstärker (A, B) über Spulen (L1, L2) mit dem T- oder Π-Glied verbunden sind und dass Ein- und Ausgang des Dämpfungsvierpoles über Kondensatoren (C1, C2) mit dem T-oder Π-Glied verbunden sind.

8. Regelbarer Dämpfungsvierpol nach einem der vorhergehenden Ansprüche, **dadurch gekennzeichnet,** dass die entsprechend einer gewünschten Dämpfung vorgewählte Spannung über einen Schalter (S1) zuführbar ist.

9. Verwendung des regelbaren Dämpfungsvierpols nach Anspruch 1, 2 oder 3 zur Dämpfung eines elektrischen Signals, insbesondere eines Hochfrequenzsignals und/oder as Referenzzelle zur Erzeugung von Regelspannungen an den Ausgängen der Operationsverstärker (A, B), welche Regelspannungen zur Steuerung von zumindest einem weiteren Dämpfungsvierpol verwendet werden.

**Claims**

1. Controllable four-terminal attenuation circuit with constant input and output resistance, comprising a series symmetrical, bridged T-element with a controllable bridging series resistance (T11) and a controllable cross resistance (T12), characterized in that the series bridging resistance (T11) is controlled by a first operational amplifier (A), which compares the input resistance of the T-element with the remaining three resistances (R3, R4, R5) of a first bridge circuit, in such a way that the input resistance of the T-element remains constant, and in that the controllable cross resistance (T12) is controlled by a second operational amplifier (B), which compares the direct-voltage portion of the output voltage of the T-element in a second bridge circuit with a desired voltage preselected according to a desired attenuation, in such a way that this direct-voltage portion assumes the value of the desired voltage and the four-terminal attenuation circuit in this way obtains the desired attenuation.

2. Controllable four-terminal attenuation circuit with constant input and output resistance, comprising a series symmetrical T-element with two controllable series resistances (T23 and T24) and a controllable cross resistance (T22), characterized in that the controllable series resistances (T23 and T24) are controlled by a first operational amplifier (A), which compares the input resistance of the T-element with the remaining three resistances (R3, R4, R5) of a first bridge circuit, in such a way that the input resistance of the T-element remains constant, and in that the controllable cross resistance (T22) is controlled by a second operational amplifier (B), which compares the direct-voltage portion of the output voltage of the T-element in a second bridge circuit with a desired voltage preselected according to a desired attenuation, in such a way that this direct-voltage portion assumes the value of the desired voltage and the four-terminal attenuation circuit in this way obtains the desired attenuation.

3. Controllable four-terminal attenuation circuit with constant input and output resistance, comprising a series symmetrical Π-element with a controllable series resistance (T35) and two controllable cross resistances (T36 and T37), characterized in that the controllable series resistance (T35) is controlled by a first operational amplifier (A), which compares the input resistance of the Π-element with the remaining three resistances (R3, R4, R5) of a first bridge circuit, in such a way that the input resistance of the Π-element remains constant, and in that the controllable cross resistances (T36 and T37) are controlled by a second operational amplifier (B), which compares the direct-voltage portion of the output voltage of the Π-element in a second bridge circuit with a desired voltage preselected according to a desired attenuation, in such a way that this direct-voltage portion assumes the value of the desired voltage and the four-terminal attenuation circuit in this way obtains the desired attenuation.

4. Controllable four-terminal attenuation circuit with a first four-terminal attenuation circuit, the input resistance and attenuation factor of which are controlled, according to one of the preceding claims, characterized in that the outputs of the operational amplifiers (A, B) are connected to the inputs of the corresponding series and cross resistances of at least a second four-terminal attenuation circuit.

5. Controllable four-terminal attenuation circuit according to claim 4, characterized in that the second or the further four-terminal circuits have an at least approximately identical control or regulation behaviour.

6. Controllable four-terminal attenuation circuit according to claim 4 or 5, characterized in that a high-frequency signal can be supplied to the first and/or the further four-terminal attenuation circuits.

7. Controllable four-terminal attenuation circuit according to claim 1, 2 or 3, characterized in that the appropriate inputs of the operational amplifiers (A, B) are connected by way of coils (L1, L2) to the T-element or Π[sic]-element and in that input and output of the four-terminal attenuation circuit are connected by way of capacitors (C1, C2) to the T-element or Π[sic]-element.

8. Controllable four-terminal attenuation circuit according to one of the preceding claims, characterized in that the voltage preselected according to a desired attenuation can be supplied by way of a switch (S1).

9. Use of the controllable four-terminal attenuation circuit according to claim 1, 2 or 3 for the attenuation of an electrical signal, in particular a high-frequency signal and/or as reference cell for the generation of control voltages at the outputs of the operational amplifiers (A, B), which control voltages are used to control at least one further four-terminal attenuation circuit.

**Revendications**

1. Quadripôle d'atténuation réglable possédant une résistance d'entrée et une résistance de sortie constantes, constitué par un circuit en T shunté à symétrie longitudinale possédant une résistance longitudinale réglable de shuntage (T11) et une résistance transversale réglable (T12), caractérisé par le fait que la résistance longitudinale de shuntage (T11) est réglée par un premier amplificateur opérationnel (A), qui compare la résistance d'entrée du circuit en T aux trois autres résistances (R3,R4,R5) d'un premier circuit en pont, de sorte que la résistance d'entrée du circuit en T reste constante, et que la résistance transversale réglable (T12) est réglée par un second amplificateur opérationnel (B), qui compare la composante de tension continue de la tension de sortie du circuit en T, dans un second circuit en pont, à une tension de consigne présélectionnée en fonction d'une atténuation désirée, de sorte que cette composante de tension continue prend la valeur de la tension de consigne et que le quadripôle d'atténuation produit de ce fait l'atténuation désirée.

2. Quadripôle d'atténuation réglable comportant une résistance d'entrée et une résistance de sortie constantes, constitué par un circuit en T shunté à symétrie longitudinale comportant deux résistances longitudinales (T23 et T124) réglables et une résistance transversale (T22) réglable, caractérisé par le fait que les résistances longitudinales (T23 et T24) réglables sont réglées par un premier amplificateur opérationnel (A), qui compare la résistance d'entrée du circuit en T aux trois autres résistances (R3,R4,R5) d'un premier circuit en pont, de sorte que la résistance d'entrée du circuit en T reste constante et que la résistance transversale (T22) réglable est réglée par un second amplificateur opérationnel (B), qui compare la composante de tension continue de la tension de sortie du circuit en T, dans un second circuit en pont, à une tension de consigne présélectionnée en fonction d'une atténuation désirée, de sorte que cette composante de tension continue prend la valeur de tension de consigne et que le quadripôle d'atténuation produit de ce fait l'atténuation désirée.

3. Quadripôle d'atténuation réglable comportant une résistance d'entrée et une résistance de sortie constantes, constitué par un circuit en Π à symétrie longitudinale comportant une résistance longitudinale réglable (T35) et deux résistances transversales réglables (T36 et T37), caractérisé par le fait que la résistance longitudinale réglable (T35) est réglée par un premier amplificateur opérationnel (A), qui compare la résistance d'entrée du circuit en Π aux trois autres résistances (R3,R4,R5) d'un premier circuit en pont, de sorte que la résistance d'entrée du circuit en Π reste constante, et que les résistances transversales réglables (T36 et T37) sont réglées par un second amplificateur opérationnel (B), qui compare la composante de tension continue de la tension de sortie du circuit en Π dans un second circuit en pont à une tension de consigne présélectionnée en fonction de l'atténuation désirée, de sorte que cette composante de tension continue prend la valeur de la tension de consigne et que le quadripôle d'atténuation produit de ce fait l'atténuation désirée.

4. Quadripôle d'atténuation réglable comportant un premier quadripôle d'atténuation, dont la résistance d'entrée et le facteur d'atténuation sont réglés, selon l'une des revendications précédentes, caractérisé en ce que les sorties des amplificateurs opérationnels (A,B) sont raccordées aux entrées des résistances longitudinales ou transversales correspondantes d'au moins un second quadripôle d'atténuation

5. Quadripôle d'atténuation réglable suivant la revendication 4, caractérisé par le fait que le second ou les autres quadripôles possèdent un comportement de commande ou de régulation au moins approximativement identique.

6. Quadripôle d'atténuation réglable suivant la revendication 4 ou 5, caractérisé par le fait qu'un signal à haute fréquence est susceptible d'être envoyé au premier quadripôle d'atténuation et/ou aux autres quadripôles d'atténuation.

**7.** Quadripôle d'atténuation réglable suivant la revendication 1, 2 ou 3, caractérisé par le fait que les entrées correspondantes des amplificateurs opérationnels (A, B) sont raccordées, par l'intermédiaire de bobines (L1,L2), au circuit en T ou en Π et que l'entrée et la sortie du quadripôle d'atténuation sont raccordées au circuit en T ou en Π par l'intermédiaire de condensateurs (C1,C2).

**8.** Quadripôle d'atténuation réglable suivant l'une des revendications précédentes, caractérisé par le fait que la tension présélectionnée en fonction d'une atténuation désirée est susceptible d'être appliquée par l'intermédiaire d'un commutateur (S1).

**9.** Utilisation du quadripôle d'atténuation réglable suivant la revendication 1, 2 ou 3 pour atténuer un signal électrique, notamment un signal à haute fréquence et/ou en tant que cellule de référence pour la production de tensions de réglage sur les sorties des amplificateurs opérationnels (A,B), lesquelles tensions de réglage sont utilisées pour commander au moins un autre quadripôle d'atténuation.

Fig. 1

8

Fig. 2

Fig. 3

EP 0 342 329 B1